# EUROPÄISCHE PATENTSCHRIFT

(11) **EP 0 575 436 B1**
(45) Veröffentlichungstag und Bekanntmachung des Hinweises auf die Patenterteilung: **28.12.1994**
(21) Anmeldenummer: 92906746.0
(22) Anmeldetag: 02.03.1992
(51) Int. Cl.: H05K 9/00

(54) **VORRICHTUNG ZUR KONTAKTIERUNG VON WANNE UND HAUBE EINES GESCHLOSSENEN GEHÄUSES**
DEVICE FOR CONTACTING THE CASING AND COVER OF A CLOSED HOUSING
DISPOSITIF POUR LA MISE EN CONTACT DU BAC ET DU CAPOT D'UN BOITIER FERME

(30) Priorität: 13.03.1991 DE 9103040 U
(43) Veröffentlichungstag der Anmeldung: 29.12.1993
(73) Patentinhaber: Siemens Nixdorf Informationssysteme Aktiengesellschaft, 33102 Paderborn (DE)
(72) Erfinder: KLAUSS, Helmut, D-8900 Augsburg (DE); STICKEL, Heinz, D-8038 Gröbenzell (DE)
(74) Vertreter: Fuchs, Franz-Josef, Dr.-Ing.
(86) Internationale Anmeldenummer: DE9200169
(87) Internationale Veröffentlichungsnummer: WO9217046

(56) Entgegenhaltungen:
- EP-A- 0 134 540
- EP-A- 0 252 203
- DE-C- 941 548
- DE-U- 8 712 020
- US-A- 2 488 710

## Beschreibung

### Vorrichtung zur Kontaktierung von Wanne und Haube eines geschlossenen Gehäuses

Die Erfindung betrifft eine Vorrichtung zur Kontaktierung von Wanne und Haube eines geschlossenen Gehäuses nach den Merkmalen des Oberbegriffs des Anspruchs 1.

Aus US-A-24 88 710 ist ein Gehäuse, bestehend aus Wanne und Haube bekannt. Sowohl die Wanne, als auch die Haube, weisen die Form eines nach mindestens einer Seite hin offenen Quaders auf und sind einstückig jeweils aus einem Blech gefertigt.

Bei elektronischen Geräten, insbesondere der Nachrichten- und Datentechnik, ist das Gehäuse in Bezug auf eine gute Abschirmung (EMV) und Funkentstörung so zu gestalten, daß der Einfluß äußerer Störgrößen möglichst gering bleibt. Bei mehrteiligen Gehäusen, die in Einzelmontage zusammengefügt werden, sind daher an den Nahtstellen besondere Maßnahmen, wie Uberlappungen, Labyrinthe, Federkontaktierungen oder aufwendige Verschraubungen erforderlich.

Wesentliche Vorteile bieten deshalb zweiteilige Gehäuse, bestehend aus Wanne und Haube. Die Wanne dient dabei als Chassis, in das die Gerätekomponenten montiert sind. Die Haube wird über die Wanne gestülpt und/oder geschoben. Dadurch ist der Störstrahlraum ohne Unterbrechung ausreichend abgeschirmt. Dies trifft jedoch nur zu, wenn ein zuverlässiger galvanischer Kontakt zwischen Wanne und Haube hergestellt werden kann. Dies ist jedoch besonders schwierig, weil mögliche Kontaktbereiche bei verschlossenem Gehäuse nicht mehr oder nur noch erschwert zugänglich sind.

Aus EP-A-0 134 540 sind Kontaktfedern zur hochfrequenzdichten Abschirmung von Flächenteilen bekannt, die ortsfest in Durchbrüchen von Flächenteilen anordenbar sind.

Der vorliegenden Erfindung liegt nun die Aufgabe zugrunde, eine Kontaktiervorrichtung der im Oberbegriff des Anspruchs 1 genannten Art so auszubilden, daß auch an schwer zugänglichen Stellen eine einfache und dennoch zuverlässige Kontaktierung zwischen Wanne und Haube möglich ist.

Diese Aufgabe wird erfindungsgemäß durch die im Anspruch 1 angegebenen Merkmale gelöst.

Vorteilhafte Weiterbildungen und Ausgestaltungen der Erfindung sind in den Unteransprüchen angegeben.

Ein Ausführungsbeispiel der Erfindung wird im folgenden anhand der Zeichnung näher erläutert. Dabei zeigen
FIG 1 ein Gehäuse, bestehend aus Wanne und Haube mit mehreren Kontaktiervorrichtungen in perspektivischer Explosionsdarstellung,
FIG 2 eine Schnittdarstellung durch die Federaufnahmefläche einer Schiene mit eingespanntem Federblechstreifen und
FIG 3 einen Schnitt quer durch die Schiene bei auf die Wanne gesetzter Haube.

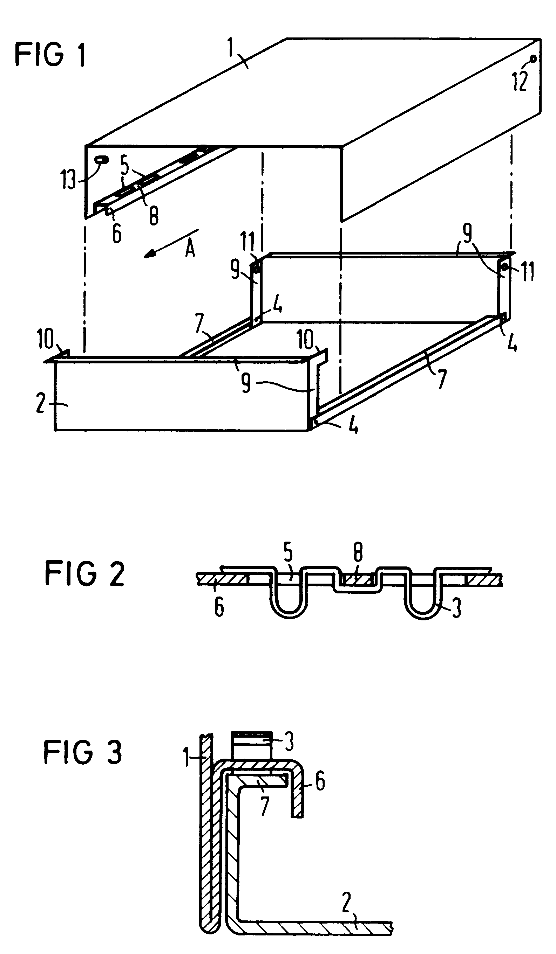

Die FIG 1 zeigt die perspektivische Explosionsdarstellung eines quaderförmigen geschlossenen Gehäuses. Das von hinten betrachtete Gehäuse besteht aus einer Wanne 2 und einer Haube 1. Sowohl Wanne 2 als auch Haube 1 sind jeweils einstückig aus einem Blech gefertigt. Die Wanne 2 besteht aus einer Unterseite, einer Frontseite und einer Rückseite des quaderförmigen Gehäuses. An den Rändern der Frontseite und Rückseite der Wanne 2, an denen die Haube 1 bei verschlossenem Gehäuse anliegt, erkennt man laschenartige Ansätze 9, die so ausgerichtet sind, daß sie parallel zur an ihr anliegenden Oberfläche der Haube 1 stehen. Die laschenartigen Ansätze 9 stehen also entweder parallel zur Oberseite des Quaders oder parallel zu den Seitenwänden des Quaders und sind durch Umbiegen der Randbereiche der Front- und Rückseite gebildet. Auch die seitlichen Randbereiche der Unterseite des Quaders sind umgebogen. Durch zweimaliges Umbiegen dieser Randbereiche sind zwei L-förmige Auflagestützen entstanden. Die eigentlichen Stützflächen (7) der Auflagestützen verlaufen parallel zur Unterseite und ragen geringfügig in das Innere der Wanne 2. Der parallel zu den Seitenwänden stehende Bereich der Auflagestützen überlappt sich an seinen Enden mit den laschenartigen Ansätzen 9. Es entstehen dabei Überlappungsstellen 4, an denen eine Verbindung der sich überlappenden Blechteile zur Versteifung der Wanne 2 vorgenommen ist. Bewerkstelligt man diese Verbindung an den Überlappungsstellen 4 durch Toxen, dann erreicht man in einem einzigen Arbeitsgang eine Verbindung, die hohe Querkräfte aufnehmen kann und zudem eine hohe Leitfähigkeit gewährleistet.

Auf die Wanne 2 ist die Haube 1 stülp- und schiebbar. Die Haube 1 besteht aus der Oberseite und den beiden Seitenwänden des quaderförmigen Gehäuses. Aus Gründen der Steifigkeit der Haube 1 kann die Haube 1 zusätzlich noch aus der Frontseite des quaderförmigen Gehäuses bestehen. An den Innenseiten der freien, der Oberseite gegenüberliegenden Randbereiche der Seitenwände ist jeweils eine Schiene 6 angeordnet. Diese Schienen 6 sind durch Biegen der angesprochenen Randbereiche gebildet. Das Profil der Schienen 6 ist U-förmig, wobei die offenen Schenkel der Schienen 6 in Richtung der Unterseite des quaderförmigen Gehäuses weisen. Der Boden des U-förmigen Profils der Schiene 6 dient als Federaufnahmefläche. Diese Federaufnahmefläche steht rechtwinkelig zur Seitenwand und damit parallel zur Oberseite des Gehäuses. In die Federaufnahmefläche sind hintereinander in Richtung der Schienenlängsausdehnung Aussparungen 5 eingebracht. Jeweils zwei der langlochartigen Aussparungen 5 sind im Gegensatz zu den benachbarten Aussparungen 5 eng zusammengerückt und durch einen Steg 8 voneinander getrennt.

In FIG 2 erkennt man einen Schnitt längs der Schiene 6 im Bereich zweier eng benachbarter Aussparungen 5. In diese Aussparungen 5 ist ein Kontaktfederblechstreifen 3 eingespannt, der drei Wölbungen aufweist. Alle drei Wölbungen weisen in Richtung der Unterseite des Gehäuses. Die mittlere Wölbung umgreift den Steg 8 von der Unterseite her formschlüssig. Die bezüglich einer Mittellinie durch die mittlere Wölbung symmetrisch angeordneten Wölbungen befinden sich etwa in der Mitte der jeweiligen langlochartigen Aussparung 5. Die äußeren Wölbungen sind größer als die mittlere Wölbung und stehen demzufolge weiter als die mittlere Wölbung von der Federaufnahmefläche in Richtung der Unterseite ab. Um den Kontaktfederblechstreifen 3 unverlierbar in die Aussparungen spannen zu können, ist der Kontaktfederblechstreifen 3 so lang, daß seine durch die Aussparungen 5 gesteckten Enden auf der zur Oberseite des Gehäuses weisenden Fläche der Federaufnahmefläche aufliegen.

Zum Aufsetzen bzw. Aufstülpen der Haube 1 auf die Wanne 2 muß die Haube 1 etwas über die Frontseite der Wanne 2 überstehen. Die Schiene 6 ist deshalb insbesondere im Bereich der Frontseite gegenüber der Länge der Seitenwände gekürzt. Wie aus FIG 3 ersichtlich, umgreift die Schiene 6 die Stützfläche 7, wenn die Haube 1 auf die Wanne 2 aufgesetzt wird. Zwischen der Stützfläche 7 und der Federaufnahmefläche befindet sich der Kontaktfederblechstreifen 3. Man erkennt, daß die Enden des Kontaktfederblechstreifens 3 gemeinsam mit den äußeren Wölbungen in Richtung der Oberseite des Gehäuses abgedrückt werden. Da die Federkraft diesem Abdrücken entgegenwirkt, ist ein zuverlässiger Kontakt zwischen Haube 1 und Wanne 2 gewährleistet.

Nach dem Aufsetzen der Haube 1 auf die Wanne 2 steht die Haube 1 an der Frontseite über die Wanne 2 hinaus. In dieser Position kann die Haube durch einfaches Anheben wieder von der Wanne 2 genommen werden. Dieses einfache Abheben der Haube 1 wird durch ein Verschieben der Haube 1 in Richtung der Rückwand (Richtung A) verhindert. Beim Zurückschieben der Haube 1 werden senkrecht in Richtung Innenraum an den Seitenwänden abstehende Bolzen 13 unter Laschen 10 geschoben. Diese Laschen 10 sind Verlängerungen der laschenartigen Ansätze 9, die durch Umbiegen der seitlichen Randbereiche der Rückseite gebildet sind. Im Frontbereich übernehmen beispielsweise Schrauben diese Aufgabe. Diese Schrauben werden durch Bohrungen 12 in der Haube 1 gesteckt und in Setzmuttern geschraubt. Diese Setzmuttern befinden sich in Bohrungen 11, die in die laschenartigen Ansätze 9 eingebracht sind, die von der Frontseite der Wanne 2 parallel zu den Seitenwänden in Richtung der Rückseite stehen.

Bei erhöhten Anforderungen an die Störstrahlungsdichtigkeit des Gehäuses können auf sämtliche laschenartige Ansätze 9 handelsübliche Kontaktfederblechstreifen geklebt, genietet, geschraubt oder gesteckt werden. Die wellenartig vorgespannten Lamellen der Kontaktfederblechstreifen spreizen sich dann zwischen die laschenartigen Ansätze 9 und der diesen Ansätzen 9 gegenüberliegenden Oberflächen der Haube 1 ein.

## Patentansprüche

1. Vorrichtung zur Kontaktierung von Wanne und Haube eines geschlossenen Gehäuses, bei dem die Haube über die Wanne schiebbar und/oder stülpbar ist, wobei sowohl die Wanne (2) als auch die Haube (1) jeweils die Form eines nach mindestens einer Seite hin offenen Quaders haben und einstückig jeweils aus einem Blech gefertigt sind,
**dadurch gekennzeichnet**, daß
- an den Innenseiten von zwei sich gegenüberliegenden Seitenwänden der Haube (1) Schienen (6) angeordnet sind, deren U-förmiges Profil eine in etwa rechtwinkelig zur Seitenwand stehende Federaufnahmefläche enthält,
- dieser Federaufnahmefläche eine mit der Wanne (2) verbundene Stützfläche (7) gegenüberliegt, die von den offenen Schenkeln der Schienen (6) umgriffen ist, und
- zwischen Federaufnahmefläche und Stützfläche (7) Kontaktfedern (3) unverlierbar angeordnet sind.

2. Vorrichtung zur Kontaktierung nach einem der vorhergehenden Ansprüche, **dadurch gekenn****zeichnet**, daß die Federaufnahmefläche parallel zur Fläche der Oberseite der Haube (1) steht.

3. Vorrichtung zur Kontaktierung nach einem der vorhergehenden Ansprüche, **dadurch gekenn****zeichnet**, daß an den Rändern der Wanne (2), an denen die Haube (1) bei verschlossenem Gehäuse anliegt, laschenartige Ansätze (9) vorgesehen sind, die so ausgerichtet sind, daß sie parallel zur an ihr anliegenden Oberfläche der Haube (1) stehen.

4. Vorrichtung zur Kontaktierung nach Anspruch 3, **da****durch gekennzeichnet**, daß zwischen den zur Haube (1) gerichteten Oberflächen der laschenartigen Ansätze (9) und der Haube (1) Kontaktfederstreifen angeordnet sind.

5. Vorrichtung zur Kontaktierung nach einem der vorhergehenden Ansprüche, **dadurch gekenn****zeichnet**, daß die laschenartigen Ansätze (9) und die Stützflächen (7) der Wanne (2) durch Biegen des Wannenbleches gebildet sind.

6. Vorrichtung zur Kontaktierung nach einem der vorhergehenden Ansprüche, **dadurch gekenn****zeichnet**, daß die Schienen (6) durch Biegen der Randbereiche der Seitenwände der Haube (1) gebildet sind.

7. Vorrichtung zur Kontaktierung nach Anspruch 5 oder 6, **dadurch gekennzeichnet**, daß die Stützflächen (7) und die laschenartigen Ansätze (9) an ihren Überlappungsstellen (4) miteinander verbunden sind.

8. Vorrichtung zur Kontaktierung bach Anspruch 7, **da****durch gekennzeichnet**, daß die Überlappungsstellen (4) durch Toxen miteinander verbunden ist.

## Claims

1. Device for contacting the trough and cover of a closed housing, in which the cover can be pushed and/or slipped over the trough, both the trough (2) and the cover (1) each having the form of a cuboid that is open at least towards one side and each being produced in one piece from a metal sheet, characterized in that
- there are arranged on the insides of two mutually opposite side walls of the cover (1) rails (6) whose U-shaped profile contains a spring receiving surface approximately at right angles to the side wall,
- a supporting surface (7) joined to the trough (2) and embraced by the open limbs of the rails (6) is opposite this spring receiving surface, and
- contact springs (3) are captively arranged between the spring receiving surface and supporting surface (7).

2. Device for contacting according to one of the preceding claims, characterized in that the spring receiving surface is parallel to the surface of the topside of the cover (1).

3. Device for contacting according to one of the preceding claims, characterized in that there are provided on the edges of the trough (2) against which the cover (1) bears when the housing is closed lug-like projections (9) which are aligned such that they are parallel to the surface of the cover (1) bearing against them.

4. Device for contacting according to Claim 3, characterized in that strip contact springs are arranged between the surfaces, directed towards the cover (1), of the lug-like projections (9) and the cover (1).

5. Device for contacting according to one of the preceding claims, characterized in that the lug-like projections (9) and the supporting surfaces (7) of the trough (2) are formed by bending the sheet metal of the trough.

6. Device for contacting according to one of the preceding claims, characterized in that the rails (6) are formed by bending the edge regions of the side walls of the cover (1).

7. Device for contacting according to Claim 5 or 6, characterized in that the supporting surfaces (7) and the lug-like projections (9) are joined to one another at their overlap points (4).

8. Device for contacting according to Claim 7, characterized in that the overlap points (4) are joined to one another by Toxes.

## Revendications

1. Dispositif de mise en contact du bac et du couvercle d'un boîtier fermé, dans lequel le couvercle peut être enfilé sur le bac et/ou peut le coiffer, tant le bac (2) que le couvercle (1) ayant chacun la forme d'un parallélépipède ouvert au moins sur une face et étant préfabriqués chacun d'une seule pièce dans une tôle, caractérisé en ce que
- sur les faces intérieures de deux parois latérales opposées du couvercle (1), sont prévues des glissières (6) dont le profil en forme de U comporte une surface de réception d'un ressort sensiblement à angle droit par rapport à la paroi latérale,
- à cette surface de réception d'un ressort, fait face une face (7) d'appui qui est reliée au bac (2) et qui est entourée par les branches ouvertes des glissières (6), et
- entre la surface de réception d'un ressort et la surface d'appui (7) sont disposés de manière imperdable des ressorts (3) de contact.

2. Dispositif de mise en contact suivant l'une des revendications précédentes, caractérisé en ce que la surface de réception d'un ressort est parallèle à la surface de la face supérieure du couvercle (1).

3. Dispositif de mise en contact suivant l'une des revendications précédentes, caractérisé en ce que sur les bords du bac (2), sur lesquels le couvercle (1) s'applique lorsque le boîtier est fermé, sont prévus des prolongements (9) en forme de pattes, dirigés de manière à être parallèles à la surface du couvercle (1) qui s'y applique.

4. Dispositif suivant la revendication 3, caractérisé en ce qu'entre les surfaces tournées vers le couvercle (1) des prolongements (9) en forme de pattes et le couvercle (1) sont prévues des bandes formant ressorts de contact.

5. Dispositif de mise en contact suivant l'une des revendications précédentes, caractérisé en ce que les prolongements (9) en forme de pattes et les surfaces (7) d'appui du bac (2) sont formés en coudant la tôle du bac.

6. Dispositif de mise en contact suivant l'une des revendications précédentes, caractérisé en ce que les glissières (6) sont formées en coudant les parties marginales des parois latérales du bac.

7. Dispositif de mise en contact suivant l'une des revendications 5 ou 6, caractérisé en ce que les surfaces (7) d'appui et les prolongements (9) en forme de pattes sont reliés entre eux en leurs points (4) de recouvrement.

8. Dispositif de mise en contact suivant la revendication 7, caractérisé en ce que les points (4) de recouvrement sont reliés entre eux par des points de matriçage suivant la technique Tox.
